# EUROPÄISCHE PATENTSCHRIFT

(11) **EP 0 994 643 B1**
(45) Veröffentlichungstag und Bekanntmachung des Hinweises auf die Patenterteilung: **27.11.2002**
(21) Anmeldenummer: 98119344.4
(22) Anmeldetag: 14.10.1998
(51) Int. Cl.: H05K 7/14, H05K 9/00

(54) **Baugruppenträger**
Rack for electronic modules
Baie pour modules électroniques

(43) Veröffentlichungstag der Anmeldung: 19.04.2000
(73) Patentinhaber: Schroff GmbH, D-75334 Straubenhardt (DE)
(72) Erfinder: Kern, Klaus, 75334 Straubenhardt (DE); Joist, Michael, 76571 Gaggenau (DE); Haag, Volker, 75323 Bad Wildbad (DE)
(74) Vertreter: Durm, Klaus, Dr.-Ing.

(56) Entgegenhaltungen:
- DE-C- 19 644 420
- DE-U- 9 402 714
- DE-U- 29 806 897

## Beschreibung

Die Erfindung bezieht sich auf einen Baugruppenträger für Steckbaugruppen mit zwei vorderen Tragschienen und mit zwei Seitenwänden, sowie mit einer Deckenplatte und einer Bodenplatte, wobei jede Tragschiene ein Dach für die Auswerf- und Einschubhilfen der Steckbaugruppen besitzt und das Dach eine Lochreihe aufweist.

Die Erfindung findet Anwendung bei Baugruppenträgern, die bei identischem Aufbau in großen Stückzahlen benötigt werden.

Zum Einbau von mit elektronischen Bauelementen bestückten Steckbaugruppen sind seit langem Baugruppenträger bekannt, die modular aufgebaut sind. Zwischen zwei Seitenwänden werden vorne und hinten jeweils oben und unten Tragschienen angebracht, wodurch ein einfacher Rahmen gebildet wird. Die Tragschienen - auch Modulschienen genannt - dienen zur Befestigung von Führungsschienen für die Steckbaugruppen, zur Befestigung der genormten Frontplatten der Steckbaugruppen, von Rückverdrahtungsplatten und von Steckverbindern. Die Öffnungen zwischen den Tragschienen werden bei Bedarf durch Deckenplatten und Bodenplatten sowie mit Rückwänden geschlossen, wobei bei HF-geschirmten Baugruppenträgern die unerwünschten Montageschlitze mit federnden Kontaktstreifen bewehrt sind. Ein derartiger Aufbau aus verschiedenen, aus stranggepreßten Aluminium-Profilschienen und gestanzten Aluminium-Blechen ist zwar flexibel, aber auch kostenintensiv. Auch die Zahl der verwendeten Einzelteile mit ihren vielen Verbindungsstellen macht sich bei HF-geschirmter Anwendung nachteilig bemerkbar.

Mit dem Gebrauchsmuster DE 298 06 897 U1 der Anmelderin ist ein Baugruppenträger bekannt geworden, bei welchem das Bodenblech und das Deckblech aus korrosionsgeschütztem Stahlblech hergestellt sind. An deren Vorderkanten sind Winkelleisten aus Stahlblech angeordnet, dabei bilden die Vorderkanten zusammen mit den Winkelleisten die vorderen Tragschienen. Diese bezüglich Boden, Decke und Modulschiene integrierte Bauweise ist preisgünstig herstellbar, läßt aber manchmal Wünsche bezüglich der Ausbildung der so hergestellten Tragschienen offen.

Es ist die Aufgabe der Erfindung, einen Baugruppenträger mit integrierten Tragschienen so auszubilden, daß diese allen Anforderungen an das Tragschienenprofil gerecht wird und rationell zu fertigen ist.

Zur Lösung der gestellten Aufgabe wird von einem Baugruppenträger der eingangs erwähnten Bauart ausgegangen und gelöst wird die Aufgabe dadurch, daß zur Erstellung der beiden vorderen Tragschienen das Dach jeweils von den vorderen Rändern der Deckenplatte und der Bodenplatte gebildet ist und auf diesen jeweils eine Profilschiene aus stranggepreßtem Aluminium befestigt ist.

Der vorgeschlagene Baugruppenträger ist rationell herstellbar und der Aufbau seiner Tragschienen durch die feste Verbindung eines Teiles seiner Decke und seines Bodens aus Stahlblech mit einer Profilschiene aus Aluminium kann normgerecht erfolgen und damit allen Gegebenheiten entsprechen.

In seiner einfachsten Ausführungsform ist zur Bildung der mit der Decke bzw. dem Boden integrierten Tragschiene die Deckenplatte und die Bodenplatte eben ausgebildet und die Profilschiene ist jeweils auf den vorderen Bereich der Platten befestigt.

Von Vorteil ist es jedoch, wenn die Deckenplatte und die Bodenplatte hinter der Profilschiene zweimal gegensinnig rechtwinklig abgekantet sind und zwischen den beiden Abkantungen einen Steg bilden. Diese Abkantung gestattet die Ausbildung einer Tragschiene in Form einer normgerechten Modulschiene.

Im einfachsten Falle ist die Profilschiene an der Deckenplatte bzw. an der Bodenplatte durch wenigstens eine elektrisch leitfähige Klebung befestigt.

Die Profilschiene kann an der Deckenplatte bzw. an der Bodenplatte auch mittels Schrauben befestigt sein.

Gemäß einer weiteren Befestigungsart sind an einer Außenwand der Profilschiene eine Reihe von hervorstehenden Zinken angeformt, die eine korrespondierende Lochreihe am Dach durchsetzen und Nietköpfe tragen.

Zur Verbesserung der Kraftübertragung zwischen Dach- und Profilschiene, zur Positionierung und um ein seitliches Ausweichen der Profilschiene zu vermeiden, trägt das Dach an seiner Oberseite eine Reihe von hervorstehenden Nasen, die in eine Haltenut an der Außenwand der Profilschiene eingreifen.

In einer bevorzugten Ausführungsform der Erfindung bezüglich der Befestigung der Profilleiste an den Dächern von solchen Decken- und Bodenplatten, die zweimal rechtwinklig abgekantet sind, weist die Profilschiene eine schmale Längsnut auf und die Deckenplatte sowie die Bodenplatte tragen an ihrer oberen Biegekante eine Anzahl von aus dem Steg herausgestanzten Lappen, die an den ihnen gegenüberliegenden Bereichen der äußeren Längsnutwand unter Preßsitz anliegen. Hierbei wird durch eine Verstemmung die Längsnutwand bereichsweise umgeformt. Der Spalt zwischen Längsnutwand und Steg wird durch Materialverdrängung am Steg geschlossen und durch eine geschickte Verformung kann Material der Längsnutwand unter die Lappen geschoben werden. Diese Befestigungsart erzeugt in Verbindung mit den am Dach hervorstehenden und in die Haltenut an der Profilschiene eingreifenden Nasen eine ungewöhnlich steife und zugleich elektrisch leitfähige Verbindung und gewährleistet ein planes Aufliegen der Profilschienen auf dem Dach.

Es ist ein bemerkenswerter Vorteil, daß die Erfindung einschließt, daß die einen U-förmigen Querschnitt aufweisende Profilschiene als normgerechte Modulschiene ausgebildet ist und hierzu mit Anlageflächen sowie einer tiefen Rinne versehen ist, an deren einander gegenüberliegenden Wänden Haltenuten zur Aufnahme von Haltemitteln und Positionselementen für die Steckbaugruppen vorgesehen sind.

Die Herstellung und die Montage des konzipierten Baugruppenträgers werden wesentlich vereinfacht, wenn die Deckenplatte und die Bodenplatte entlang ihrer langen Seiten hochgebogene Befestigungsleisten aufweisen, an welchen die Seitenwände angebracht sind.

Zur Bildung der hinteren, oberen und unteren Tragschienen des Baugruppenträgers können in kostensparender Weise an der Hinterseite von Deckenplatte und Bodenplatte jeweils Abkantungen des hinteren Randes gebildet sein.

Die Erfindung wird nachstehend an einem Ausführungsbeispiel unter Bezugnahme auf die beigefügten Zeichnungen näher erläutert. Dabei zeigen:
- Fig. 1: einen Baugruppenträger in einer explosionsartigen, perspektivischen Darstellung,

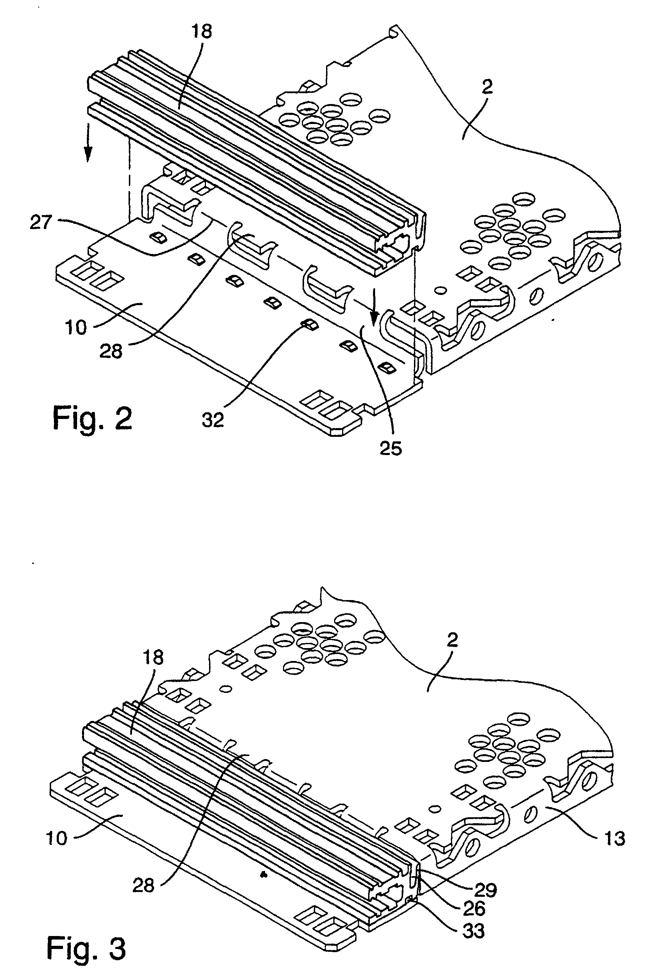

- Fig. 2: einen Ausschnitt des vorderen Teiles einer Bodenplatte des Baugruppenträgers nach Fig. 1 zusammen mit einer Profilschiene vor deren Befestigung an der Bodenplatte, in Perspektive und vergrößertem Maßstab,
- Fig. 3: den Auschnitt nach Fig. 2 mit auf der Bodenplatte befestigter Profilschiene,
- Fig. 4: den vorderen Teil der Bodenplatte des Baugruppenträgers nach Fig. 1 mit auf dem Dach aufgesetzter Profilschiene, in stark vergrößertem Maßstab,
- Fig. 5: den vorderen Teil der Bodenplatte nach Fig. 4 mit durch einen Stempel unter die hervorstehenden Lappen verformter Längswand der Längsnut der Profilschiene.

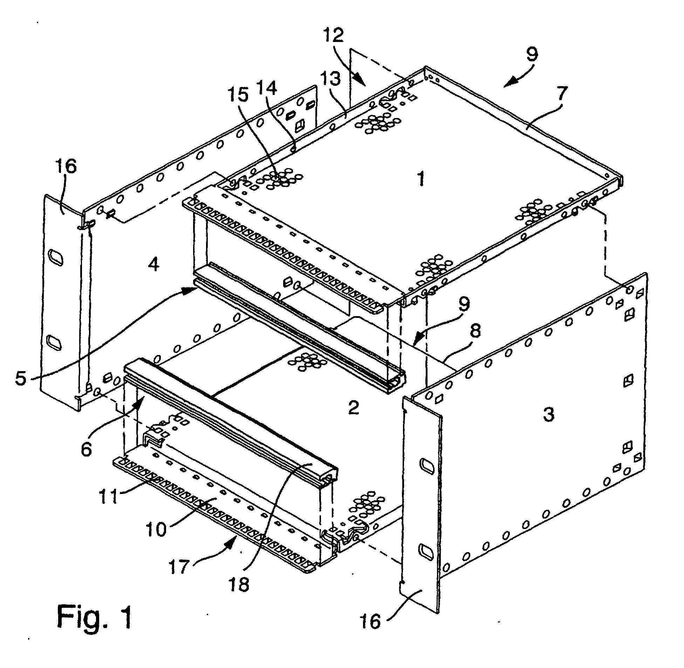

Der in Fig. 1 wiedergegebene Baugruppenträger besteht aus einer Deckenplatte 1, einer Bodenplatte 2, einer rechten Seitenwand 3, einer linken Seitenwand 4, einer oberen, vorderen Tragschiene 5 und einer unteren, vorderen Tragschiene 6. Zwei hintere Tragschienen 7 und 8 sind durch die hinteren abgekanteten Ränder 9 der Deckenplatte 1 und der Bodenplatte 2 gebildet.

Die Deckenplatte 1 und die Bodenplatte 2 sind Stanzteile aus oberflächengeschütztem Stahlblech, während die beiden Seitenwände 3 und 4 aus ausgestanzten, eloxierten Aluminiumblechen hergestellt sind.

Jede der beiden Tragschienen 5 und 6 besitzen ein Dach 10 in Gestalt einer breiten, vorderen Randleiste, die eine Lochreihe 11 aufweist, welche zum Eingriff für Auswerf- und Einschubhilfen für die Steckbaugruppen (nicht dargestellt) dienen.

Die Deckenplatte 1 und die Bodenplatte 2 weisen an ihren langen Seiten 12 hochgebogene Befestigungsleisten 13 auf, die Schraubenlöcher 14 tragen und an welchen die Seitenwände 3 bzw. 4 befestigt sind. Deckenplatte 1 und Bodenplatte 2 sind mit Gruppen von Lüftungslöchern 15 versehen.

An der Hinterseite der Deckenplatte 1 und der Bodenplatte 2 ist jeweils zur Bildung der hinteren Tragschiene 7 und 8 des Baugruppenträgers eine Abkantung des hinteren Randes 9 vorgesehen. Alternativ ist eine Ausgestaltung der hinteren Tragschienen 7, 8 analog zu den vorderen Tragschienen 5, 6 denkbar.

An den beiden Seitenwänden 3 und 4 sind rechtwinklig nach außen stehende Befestigungsflansche 16 angebracht, mit denen der Baugruppenträger in einem Geräteschrank, einem Gehäuse oder einem Rahmengestell befestigt werden kann.

Das Dach 10 der beiden Tragschienen 5 und 6 ist jeweils von den vorderen Rändern 17 der Deckenplatte 1 bzw. der Bodenplatte 2 gebildet.

Hinter der Lochreihe 11 des Daches 10 ist jeweils sowohl auf der Deckenplatte 1 wie auf der Bodenplatte 2 eine Profilschiene 18 aus stranggepreßtem Aluminium befestigt.

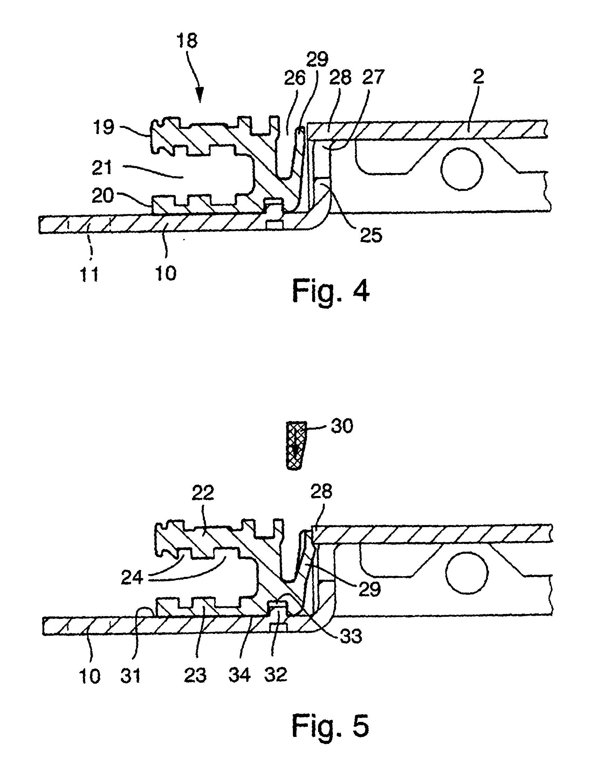

Die Profilschiene 18 besitzt (vgl. Figuren 4 und 5) einen im wesentlichen U-förmigen Querschnitt und ist als normgerechte Modulschiene ausgebildet. Diese ist hierzu mit Anlageflächen 19 und 20 für die Frontplatten der Steckbaugruppen versehen und sie trägt eine tiefe Rinne 21, an deren einander gegenüberliegenden Wänden 22 und 23 Haltenuten 24 zur Aufnahme von (nicht dargestellten) Haltemitteln und Positionierelementen - beispielsweise Gewindelochstreifen und Justierbändern und Lochreihen - für die Steckbaugruppen vorgesehen sind.

Hinter der Profilschiene 18 sind die Deckenplatte 1 sowie die Bodenplatte 2 zweimal gegensinnig rechtwinklig abgebogen, wobei zwischen den beiden Abkantungen ein schmaler Steg 25 entsteht - vgl. insbesondere Fig. 4.

Die Profilschiene 18 kann an der Deckenplatte 1 bzw. der Bodenplatte 2 durch eine Klebung, mittels Schrauben oder durch Zinken, die in eine Lochreihe eingreifen und dort vernietet werden, befestigt sein. Bei dem dargestellten Ausführungsbeispiel (siehe Figuren 4 und 5) geschieht die Befestigung dadurch, daß die Profilschiene 18 eine schmale und tiefe Längsnut 26 aufweist und die Deckenplatte 1 bzw. die Bodenplatte 2 an ihrer oberen Biegekante 27 eine Anzahl von aus dem Steg 25 herausgestanzten Lappen 28 tragen. Diese Lappen 28 liegen in der Ebene der Deckplatte 1 bzw. der Bodenplatte 2. Die Profilschiene 18 lehnt sich mit ihren den Lappen 28 gegenüberliegenden Bereichen der äußeren und nach außen verformten Längswand 29 der Längsnut 26 unter Preßsitz an die Lappen 28 an. Die Verformung der Längswand 29 und der hierdurch erzielte Preßsitz wird erreicht durch eine Verstemmung, indem ein konischer Stempel 30 in die Längsnut 26 eingedrückt wird - siehe Fig. 5. Durch geschickte Verformung wird partiell die Längswand unter die Lappen 28 gedrückt. Um dabei einem Ausweichen der Profilschiene 18 entgegenzuwirken, trägt das Dach 10 auf seiner Oberseite 31 eine Reihe von hervorstehenden Nasen 32, die in eine niedere Haltenut 33 an der Außenwand 34 der Profilschiene 18 eingreifen. Die fest mit der Deckenplatte 1 bzw. der Bodenplatte 2 verbundenen Profilschienen 18 bilden vordere Tragschienen 5 bzw. 6, die bei entsprechender Dimensionierung und Ausgestaltung eine normgerechte Modulschiene ergeben.

### Zusammenstellung der verwendeten Bezugszeichen

- 1: Deckenplatte
- 2: Bodenplatte
- 3: (rechte) Seitenwand
- 4: (linke) Seitenwand
- 5: (obere) vordere Tragschiene
- 6: (untere) vordere Tragschiene
- 7: (hintere) Tragschiene
- 8: (hintere) Tragschiene
- 9: (hintere) Ränder
- 10: Dach
- 11: Lochreihe
- 12: lange Seite
- 13: Befestigungsleiste
- 14: Schraubenlöcher
- 15: Lüftungslöcher
- 16: Befestigungsflansche
- 17: (vordere) Ränder
- 18: Profilschienen
- 19: Anlageflächen
- 20: Anlageflächen
- 21: Rinne
- 22: Wand
- 23: Wand
- 24: Haltenuten
- 25: Steg
- 26: Längsnut
- 27: Biegekante
- 28: Lappen
- 29: Längswand
- 30: Stempel
- 31: Oberseite
- 32: Nasen
- 33: Haltenut
- 34: Außenwand

## Patentansprüche

1. Baugruppenträger für Steckbaugruppen
- mit zwei vorderen Tragschienen,
- mit zwei Seitenwänden,
- mit einer Deckenplatte und einer Bodenplatte,
- jede Tragschiene besitzt ein Dach für die Auswerf- und Einschubhilfen der Steckbaugruppen,
- das Dach weist eine Lochreihe auf,
**gekennzeichnet durch** folgende Merkmale:
- zur Erstellung der beiden vorderen Tragschienen (1 und 2) ist das Dach (10) jeweils von den vorderen Rändern (17) der Deckenplatte (1) und der Bodenplatte (2) gebildet,
- hinter dem Rand (17) des Daches (10) ist jeweils auf der Deckenplatte (1) und auf der Bodenplatte (2) eine Profilschiene (18) aus stranggepreßtem Aluminium befestigt.

2. Baugruppenträger nach Anspruch 1, **dadurch gekennzeichnet, daß** die Deckenplatte (1) und die Bodenplatte (2) hinter der Profilschiene (18) zweimal gegensinnig rechtwinklig abgekantet sind und zwischen den beiden Abkantungen einen Steg (25) bilden.

3. Baugruppenträger nach Anspruch 1 oder 2, **dadurch gekennzeichnet, daß** die Profilschiene (18) an der Deckenplatte (1) bzw. an der Bodenplatte (2) durch wenigstens eine elektrisch leitfähige Klebung befestigt sind.

4. Baugruppenträger nach Anspruch 1 oder 2, **dadurch gekennzeichnet, daß** die Profilschiene (18) an der Deckenplatte (1) bzw. an der Bodenplatte (2) mittels Schrauben befestigt sind.

5. Baugruppenträger nach Anspruch 1 oder 2, **dadurch gekennzeichnet, daß** an einer Außenwand der Profilschiene (18) eine Reihe von hervorstehenden Zinken angeformt ist, die eine korrespondierende Lochreihe am Dach (10) durchsetzen und Nietköpfe tragen.

6. Baugruppenträger nach einem der Ansprüche 1 bis 4, **dadurch gekennzeichnet, daß** das Dach (10) auf seiner Oberseite (31) eine Reihe von hervorstehenden Nasen (32) trägt, die in eine Haltenut (33) an der Außenwand (34) der Profilschiene (18) eingreifen.

7. Baugruppenträger nach den Ansprüchen 1, 2 oder 6, **dadurch gekennzeichnet, daß** die Profilschiene (18) eine schmale Längsnut (26) aufweist und die Deckenplatte (1) sowie die Bodenplatte (2) an ihrer oberen Biegekante (27) eine Anzahl von aus dem Steg (25) herausgestanzten Lappen (28) tragen, die an den ihnen gegenüberliegenden Bereichen der äußeren Längsnutwand (26) unter Preßsitz anliegen und partiell untergreifen.

8. Baugruppenträger nach einem der Ansprüche 1 bis 7, **dadurch gekennzeichnet, daß** die einen U-förmigen Querschnitt aufweisende Profilschiene (18) als normgerechte Modulschiene ausgebildet ist und hierzu mit Anlageflächen (19 und 20) sowie einer tiefen Rinne (21) versehen ist, an deren einander gegenüberliegenden Wänden (22 und 23) Haltenuten (24) zur Aufnahme von Haltemitteln und Positionierelementen für die Steckbaugruppen vorgesehen sind.

9. Baugruppenträger nach einem der Ansprüche 1 bis 8, **dadurch gekennzeichnet, daß** an der Hinterseite von Deckenplatte (1) und Bodenplatte (2) jeweils eine Abkantung des hinteren Randes (9) als eine hintere Tragschiene (7, 8) gebildet ist.

10. Baugruppenträger nach einem der Ansprüche 1 bis 9, **dadurch gekennzeichnet, daß** die Deckenplatte (1) und die Bodenplatte (2) entlang ihrer langen Seiten (12) hochgebogene Befestigungsleisten (13) aufweisen, an welchen die Seitenwände (3 und 4) befestigt sind.

## Claims

1. Rack for plug-in electronic modules
- with two front carrier rails,
- with two side walls,
- with cover plate and floor plate,
- each carrier rail having a roof for the ejection and insertion aids of the plug-in modules,
- the roof having a row of apertures,
**characterised by** the following features:
- in order to produce the two front carrier rails (1 and 2), the roof (10) is respectively formed from the front edges (17) of the cover plate (1) and the floor plate (2),
- behind the edges (17) of the roof (10), a respective profiled rail (18) from extruded aluminium is secured to the cover plate (1) and to the floor plate (2).

2. A rack for electronic modules according to claim 1, **characterised in that** the cover plate (1) and floor plate (2) are bent twice orthogonally and in opposite senses behind the profiled rails (18) and between the two bends form a web (25).

3. A rack for electronic modules according to claim 1 or 2, **characterised in that** the profiled rails (18) are secured to the cover plate (1) and the floor plate (2) by means of at least one electrically conductive adhesive joint.

4. A rack for electronic modules according to claim 1 or 2, **characterised in that** the profiled rails (18) are secured to the cover plate (1) and the floor plate (2) by screws.

5. A rack for electronic modules according to claim 1 or 2, **characterised in that** a row of projecting abutments are formed on the outer wall of the profiled rails (18) and project into a corresponding row of holes at the roof (10) and carry rivet heads.

6. A rack for electronic modules according to one of claims 1 to 4, **characterised in that** the roof (10) carries a row of projecting noses (32) on its upper side (31) engaging into a retaining groove (33) at the outer wall (34) of the profiled rail (18).

7. A rack for electronic modules according to claims 1, 2 or 6, **characterised in that** the profiled rail (18) has a narrow longitudinal groove (26) and the cover plate (1) as well as the floor plate (2) have at their upper bent edge (27) a number of tabs (28) stamped out of the web (25), which tabs (28) bear against the oppositely lying regions of the outer longitudinal groove wall (26) by a press-fit and partially engage under them.

8. A rack for electronic modules according to one of claims 1 to 7, **characterised in that** the profiled rail (18) having a U-shaped cross-section is formed as standardised modular rails and is provided to this end with bearing surfaces (19 and 20) as well as a deep channel (21), the oppositely lying walls (22 and 23) of which are provided with retaining grooves (24) for receiving retaining means and positioning elements for the plug-in electronic modules.

9. A rack for electronic modules according to one of claims 1 to 8, **characterised in that** a respective bend of the rear edge (9) at the rear side of the cover plate (1) and the floor plate (2) is formed as a rear carrier rail (7, 8).

10. A rack for electronic modules according to one of claims 1 to 9, **characterised in that** the cover plate (1) and the floor plate (2) have bent-up securing strips (13) along their long sides (12) to which strips the side walls (3 and 4) are secured.

## Revendications

1. Baie pour modules électroniques enfichables
- avec deux profilés supports avant,
- avec deux parois latérales,
- avec une plaque de couverture et une plaque de fond,
- chaque profilé support présente un toit pour les auxiliaires d'éjection et d'insertion des modules enfichables,
- le toit présente une rangée de trous,
**caractérisée par** les caractéristiques suivantes :
- pour la réalisation des deux profilés supports avant (1 et 2), le toit (10) est respectivement formé par les bords avant (17) de la plaque de couverture (1) et de la plaque de fond (2),
- derrière le bord (17) du toit (10), un rail profilé (18) en aluminium extrudé est respectivement fixé sur la plaque de couverture (1) et sur la plaque de fond (2).

2. Baie pour modules électroniques suivant la revendication 1, **caractérisée en ce que** la plaque de couverture (1) et la plaque de fond (2) sont pliées deux fois en sens contraire en angle droit derrière le rail profilé (18) et forment une traverse (25) entre les deux pliures.

3. Baie pour modules électroniques suivant l'une des revendication 1 et 2, **caractérisée en ce que** le rail profilé (18) est fixé sur la plaque de couverture (1) ou respectivement sur la plaque de fond (2) par au moins un collage conducteur électriquement.

4. Baie pour modules électroniques suivant l'une des revendications 1 et 2, **caractérisée en ce que** le rail profilé (18) est fixé sur la plaque de couverture (1) ou respectivement sur la plaque de fond (2) au moyen de vis.

5. Baie pour modules électroniques suivant l'une des revendications 1 et 2, **caractérisée en ce qu'**une rangée de pointes en saillie, qui traversent une rangée de trous correspondante sur le toit (10) et supportent des têtes de rivets, est conformée sur une paroi extérieure du rail profilé (18).

6. Baie pour modules électroniques suivant l'une des revendications 1 à 4, **caractérisée en ce que** le toit (10) supporte sur son côté supérieur (31) une rangée d'ergots (32) en saillie, qui s'engagent dans une rainure de retenue (33) sur la paroi extérieure (34) du rail profilé (18).

7. Baie pour modules électroniques suivant les revendications 1, 2 ou 6, **caractérisée en ce que** le rail profilé (18) présente une rainure longitudinale étroite (26) et la plaque de couverture (1), ainsi que la plaque de fond (2), supportent sur leur arête de flexion supérieure (27) un nombre de languettes (28) découpées dans la traverse (25), qui s'appliquent avec ajustement serré sur les zones qui leur sont en vis-à-vis de la paroi de rainure longitudinale extérieure (29) et les enserrent partiellement.

8. Baie pour modules électroniques suivant l'une des revendications 1 à 7, **caractérisée en ce que** le rail profilé (18) présentant une section transversale en U est réalisé sous forme de rail modulaire conforme aux normes et est muni à cet effet de surfaces d'appui (19 et 20), ainsi que d'une.goulotte profonde (21), sur les parois (22 et 23) en vis-à-vis mutuel de laquelle sont prévues des rainures de retenue (24) pour recevoir des moyens de fixation et des éléments de positionnement pour les modules enfichables.

9. Baie pour modules électroniques suivant l'une des revendications 1 à 8, **caractérisée en ce qu'**une pliure du bord arrière (9) est respectivement formée sous forme de profilé support arrière (7, 8) sur le côté arrière de la plaque de couverture (1) et de la plaque de fond (2).

10. Baie pour modules électroniques suivant l'une des revendications 1 à 9, **caractérisée en ce que** la plaque de couverture (1) et la plaque de fond (2) présentent le long de leurs longs côtés (12) des barres de fixation (13) pliées vers le haut, sur lesquelles sont fixées les parois latérales (3 et 4).
